# EUROPÄISCHE PATENTSCHRIFT

(11) **EP 2 386 870 B1**
(45) Veröffentlichungstag und Bekanntmachung des Hinweises auf die Patenterteilung: **29.11.2017**
(21) Anmeldenummer: 11000833.1
(22) Anmeldetag: 03.02.2011
(51) Int. Cl.: G01R 31/26

(54) **Isolationstestverfahren für Photovoltaikgrossanlagen**
Isolation test method for large-scale photovoltaic assemblies
Procédé de test d'isolation pour grandes installations photovoltaïques

(30) Priorität: 16.03.2010 DE 102010011476
(43) Veröffentlichungstag der Anmeldung: 16.11.2011
(73) Patentinhaber: Adensis GmbH, 01129 Dresden (DE)
(72) Erfinder: Beck, Bernhard, 97332 Volkach OT Dimbach (DE)
(74) Vertreter: Bauer, Daniel

(56) Entgegenhaltungen:
- DE-B3-102004 018 918
- US-A- 5 475 558
- US-A- 5 712 572
- US-A1- 2003 214 306

## Beschreibung

Die Erfindung bezieht sich auf ein Verfahren zur Überprüfung der Isolation einer Photovoltaikanlage gegenüber Erde mit Hilfe eines auf die Anschlussleitungen der Photovoltaikanlage gegebenen Testimpulses.
Aus der Druckschrift WO/25374 ist ein Verfahren zum Schutz einer PV-Anlage bekannt. Dort wird reagiert, wenn bereits ein Schaden aufgetreten ist, indem versucht wird, die Auswirkungen des Schadens auf die Photovoltaikanlage zu begrenzen, indem die mit dem Kurzschlusslichtbogen einhergehende elektromagnetische Strahlung detektiert wird und betroffene Anlagenteile vom Kurzschluss isoliert werden. Aus der Druckschrift DE 10 2004 018918 ist eine Isolationsfehlerortung auf dem Wechselspannungsgebiet bekannt, bei dem jedes zuschaltbare Teilnetz mit einem eigenen Prüfgenerator, einem eigenen Isolationsüberwachungsgerät und einem eigenen Differenzstromwandel versehen ist.
In der US 5155441 ist ein Wechselspannungssystem beschrieben, bei dem ein einziges Isolationstestgerät sequentiell für die Überwachung mehrerer Motoren eingesetzt wird, die dann spannungslos und ruhend sein müssen.
Schließlich ist es aus der DE 69213626 bekannt, mehrere Wechselspannungsteilnetze über zugeordnete Leistungsschalter zu versorgen. Kopplungsleistungsschalter dienen dazu, eine vorgebbare Netzkonfiguration herbeizuführen. Jedem Netzabschnitt ist dann ein eigener Gesamtisolationswächter zugeordnet und jedem Zweig von jedem Netzabschnitt ein lokaler Isolationswächter. Die Dokumente US 5,712,572A, DE10 2004018918B und US 5475558A beschreiben verschiedene Methoden um eine Photovoltaikanlage zu überprüfen. Das eingangs erwähnte Verfahren ist bei Photovoltaikanlagen üblich, um einen Erdschluss oder eine drohende Isolationsschwäche frühzeitig zu erkennen. Dazu wird ein sogenannter Isolationswächter an die Anschlussleitungen angeschlossen, der den Testimpuls erzeugt und auf die Anschlussleitungen gibt. Der Testimpuls wird dabei an dem Eingang des Wechselrichters gegeben, der den photovoltaisch erzeugten Gleichstrom zur Einspeisung in ein Versorgungsnetz in einen Wechselstrom umwandelt. Aufgrund der Fortschritte in der Halbleitertechnologie bei Leistungstransistoren sind heute Wechselrichter bis zu einem MW verfügbar. Bei den dazu gehörigen Großanlagen ist der Einsatz der klassischen Isolationswächter nicht erfolgreich, da aufgrund der Größe des vorhandenen Leitungsnetzes zu hohe Kapazitäten auftreten, die den Testimpuls so dämpfen, dass keine zuverlässige Aussage über den Isolationszustand mehr getroffen werden kann. Modifikationen am Isolationswächter haben bis jetzt keine befriedigende Lösung erreichen können.

Es ist die Aufgabe vorliegender Erfindung hier Abhilfe zu schaffen und auch beliebig große Photovoltaikanlagen mit einem Standardtestgerät überprüfen zu können.

Diese Aufgabe wird nach einer ersten Ausführungsform der Erfindung dadurch gelöst, dass die Photovoltaikanlage schaltungstechnisch in mehrere, elektrisch voneinander isolierte Teilanlagen gegliedert wird, und der Testimpuls nacheinander auf die der jeweiligen Teilanlage zugeordnete Anschlussleitung gegeben wird.

Es wird hier also nicht der naheliegende Weg beschritten, das Testgerät weiterzuentwickeln, sondern es wird der Weg eingeschlagen, die Photovoltaikanlage so zu ändern oder besser aufgliederbar zu machen, das Standardgeräte eingesetzt werden können. Dieses erfordert zwar einen erhöhten Geräteaufwand, der aber hingenommen werden kann.

Die schaltungstechnische Zerlegung in Teilanlagen sollte so sein, dass jede Teilanlage mehrere Photovoltaikfelder umfasst, nämlich so viele, dass deren Leitungslängen von dem verwendeten Impulstestgerät beherrschbar sind. Die Leitungen sind dabei auf eine Sammelschiene zuschaltbar, die wiederum an den Eingang eines Wechselrichters geführt ist.

Die Verbindung der Teilanlagen, gegebenenfalls der einzelnen PV-Felder,
sollten über ein zweipoliges Schaltmittel an den Ausgang eines den Testimpuls generierenden Isolationswächters angeschlossen sein. Im Isolationswächter kann dazu ein Multiplexer angeordnet sein, der nacheinander ein Testsignal auf die an den Ausgang des Multiplexers angeschlossenen Leitungen zu den jeweiligen Teilanlagen gibt. Alternativ kann das zweipolige Schaltmittel eine Vielzahl von elektronischen Schaltern umfassen, die die beiden jeweiligen Anschlussleitungen zu den Teilanlagen an eine Testimpuls-Sammelleitung schaltet oder von ihr trennt, auf welcher der Testimpuls gegeben und von dort über die Schaltmittel an die einzelnen Teilanlagen verteilt wird.

Gemäß einer zweiten Ausführungsform der Erfindung wird die gestellte Aufgabe dadurch gelöst, dass der Stromverlauf des Testimpuls durch die Anschlussleitungen mittels Stromsensoren an geeigneten Stellen erfasst wird. Auch hier wird eine anlagenseitige Modifikation vorgenommen, die einmalig einen erhöhten Material- und Montageeinsatz erfordert, der durch die Vorteile des Einsatzes von Standardgeräten zur Isolationsüberwachung aber kompensiert wird.

Es ist vorteilhaft, wenn in zeitlicher Nähe zur Errichtung der Anlage eine erste Serie von Messimpulsen generiert wird und deren Verlauf, Verzweigung und/oder Verteilung im Leitungsnetz der Anschlussleitungen zu dem einen oder den mehreren PV-Feldern protokolliert wird. So wird z.B. unmittelbar nach der Errichtung der Photovoltaikanlage eine Referenz geschaffen, wie die Isolation im Idealfall auszusehen hat, ohne dass durch Verschmutzung, Alterung, Erhöhung von Kontaktübergangswiderständen etc. ein Verschlechterung eingetreten ist. Nach einer wählbaren Zeit später wird dann der Verlauf des Testimpulses mit einem entsprechenden Verlauf zu dem früheren Zeitpunkt verglichen. Aus den Veränderungen können dann Rückschlüsse auf zwischenzeitlich aufgetretene Isolationsmängel gezogen werden.

Die Stromsensoren sind vorzugsweise an den von einer Sammelschiene ausgehenden Zuleitungen zu einzelnen Feldern der Photovoltaikanlage vorgesehen. Dieses ist insbesondere vorteilhaft, wenn weitere Schaltmittel vorgesehen sind, die die jeweiligen Anschlussleitungen zu einzelnen Feldern an die Sammelschiene zuschalten oder von ihr trennen. Die Sammelschiene ist dabei mit dem Eingang des Wechselrichters verbunden.

Weitere Vorteile und Ausgestaltungen der Erfindung ergeben sich aus der Beschreibung eines Ausführungsbeispiels anhand der Figur. Diese zeigt:
- Fig.1: eine Vorrichtung zur Durchführung der Verfahren nach einer ersten Ausführungsform mit Stromflussüberwachung,
- Fig.2: eine Vorrichtung zur Durchführung der Verfahren nach einer zweiten Ausführungsform mit Testimpuls-Sammelschiene, und
- Fig.3: eine Vorrichtung zur Durchführung der Verfahren nach einer dritten Ausführungsform mit Multiplexer.

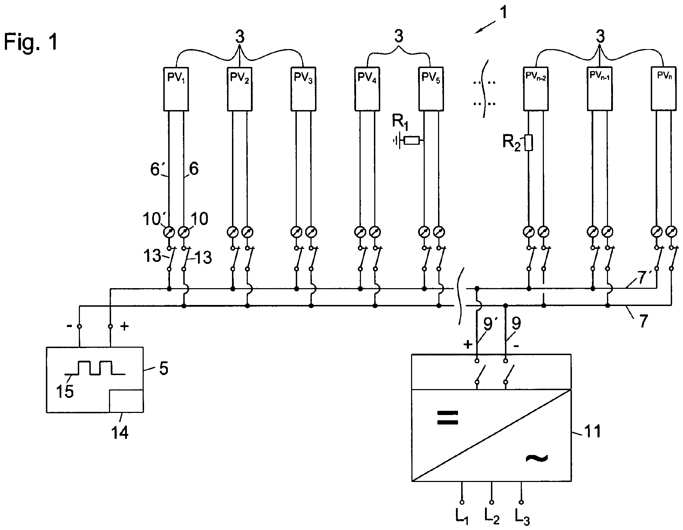

In der Figur 1 ist eine Photovoltaikgroßanlage 1 gezeigt, die in n Teilanlagen 3 gegliedert ist. Die ersten fünf Teilanlagen 3 sind auch als PV1 bis PV5 bezeichnet und die letzten beiden Teilanlagen 3 sind mit PVn-1 und PVn bezeichnet. Jede der Teilanlagen 3 umfasst mehrere, parallel geschaltete Photovoltaikfelder, z.B. 8 Felder (nicht gezeigt). Eine übliche Größe für ein Feld wiederum sind zehn parallel geschaltete Stränge zu jeweils 10 in Reihe geschalteten Photovoltaikmodule. Jedes Modul wiederum weist z.B. 60 in Reihe geschaltete Photozellen auf. Acht Felder zu je 10 Strängen ergibt 80 Stränge. Zehn Stränge zu je 10 PV-Modulen ergibt dann 800 PV-Module pro Teilanlage 3. Dieses ist eine Größenordnung, in welcher der Einsatz eines herkömmlichen Isolationswächters 5 sinnvoll ist.

Bei heute verfügbaren PV-Großanlagen sind beispielsweise n=20 dieser Teilanlagen 3 direkt über Zuleitungen 6,6' mit zwei Sammelschienen 7,7' verbunden, die an den jeweiligen Plus- und Minuseingang 9 eines Wechselrichters 11 angeschlossen sind. In den Stromleitungen 6,6' sind Stromwandler 10,10' vorgesehen, von denen vorzugsweise jeweils einer 10' in der zum positiven Pol 9' der PV-Anlage führenden Leitung 6' und einer 10 in die zum negativen Pol 9 führende Leitung 6 vorgesehen ist.

Von den an einen Wechselrichter 11 angeschlossenen Sammelleitungen 7,7' gehen die Zuleitungen 6,6' zu den Teilanlagen 3 über einen 2-poligen Trennschalter 13 ab. Der Trennschalter 13 ist wegen des hohen zu schaltenden Stromes ein mechanischer Schalter 13, der beim eigentlichen Schaltvorgang einen erheblichen Lichtbogen zieht, was zu einem Verschleiß der Schalterkontakte führt. Entsprechend sparsam ist mit Schaltvorgängen umzugehen.

Dies erlaubt vorliegende erste Ausführungsform, indem der Isolationswächter 5 seinen Testimpuls 15 unmittelbar auf die Sammelleitungen 7,7' gibt, ohne dass die Trennschalter 13 zu betätigen wären. Dieses kann zum Beispiel nachts vorgenommen werden, wo keine Solar-technisch erzeugte Spannung vorliegt. Bei entsprechend hochohmiger Isolation des Isolationswächters 5 kann der Testimpuls 15 auch tagsüber bei laufendem Betrieb der Photovoltaikanlage 1 auf die Sammelleitungen 7,7' aufmoduliert werden.

Sind die Zuleitungen 6,6' zu allen Teilanlagen 3 und auch die Teilanlagen 3 selber in einwandfrei isoliertem Zustand, so würde der auf die positive Sammelleitung 7' gegebene Testimpuls 15 sich nach den jeweils vorliegenden Leitungslängen mehr oder weniger gleichmäßig auf die Teilanlagen 3 verteilen und die Strommessgeräte 10' würden in etwa den gleichen Wert anzeigen. Die den Rückstrom messenden Strommessgeräte 10 zeigen bis auf die zu erwartenden Dämpfungsverluste ebenfalls den gleichen Stromwert an.

In der Figur 1 sind in den Zuleitungen 6,6' zu den Teilanlagen PV5 und PV n-2 zwei Widerstände R1 und R2 eingezeichnet, die symbolhaft eine Unregelmäßigkeit darstellen. Der Widerstand R1 kann z.B. ein Stromnebenpfad sein, der durch Bewuchs von Gras an eine freiliegende Kabelseele zustande kommt. An dieser Stelle würde das Strommessgerät 10' einen höheren Wert anzeigen als das Strommessgerät 10, da der Testimpuls 15 nicht gänzlich zu der Sammelleitung 6 zurückgeführt wird, sondern zum Teil gegenüber Erde abgeleitet wurde. Analog ist der Widerstand R2 zum Beispiel ein über die Zeit aufgetretener, verschlechterter Kontaktübergang. Das würde sich dahingehend bemerkbar machen, dass die zugeordneten Stromwandler 10,10' der Teilanlage PVn-2 zwar denselben Wert messen, dieser aber im Vergleich zu den bei anderen Teilanlagen PVn gemessenen Stromwerten deutlich geringer ist. Auf diese Weise kann durch eine Analyse des Stromverlaufs in den Zuleitungen 6,6' auf den Zustand der Isolation der jeweiligen Teilanlagen PVn geschlossen werden. Eine entsprechende Analyseeinheit 14 kann in dem Isolationswächter 5 integriert sein.

Unmittelbar nach der Errichtung der PV-Anlage 1 kann eine Serie von Testimpulsen 15 erstmals auf die Zuleitungen 6,6' gegeben werden. Unterstellt, dass während der Inbetriebnahmephase alle erkannten Isolationsschwächen beseitigt wurden, liegt so eine Referenzverteilung der Ströme vor, die widerspiegelt, wie sich der Testimpuls 15 innerhalb der Anlage 1 ausbreitet. Die gemessenen Ströme von allen vorhandenen Stromwandlern 10,10' werden protokolliert, so dass sie bei einer späteren Vergleichsmessung zur Verfügung stehen. Die Analyseeinheit 14 überprüft dann, wie sich die Stromverteilung geändert hat und gibt bei Vorliegen einer unzulässig hohen Änderung, von z.B. plus/minus 10% Abweichung vom ursprünglichen Messwert, ein Warnsignal ab.

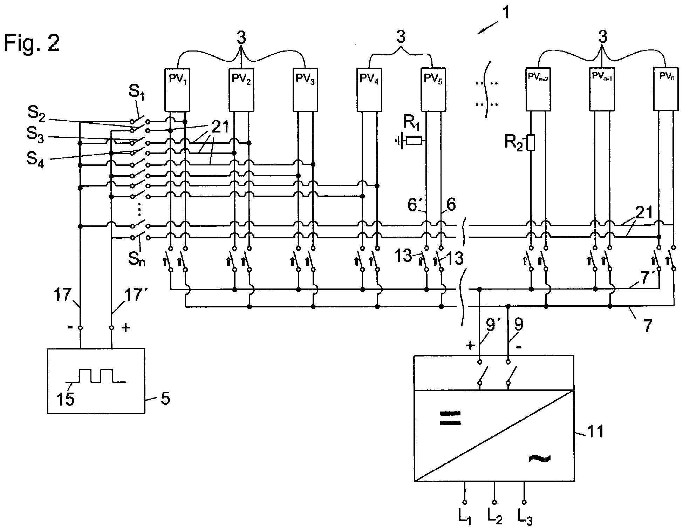

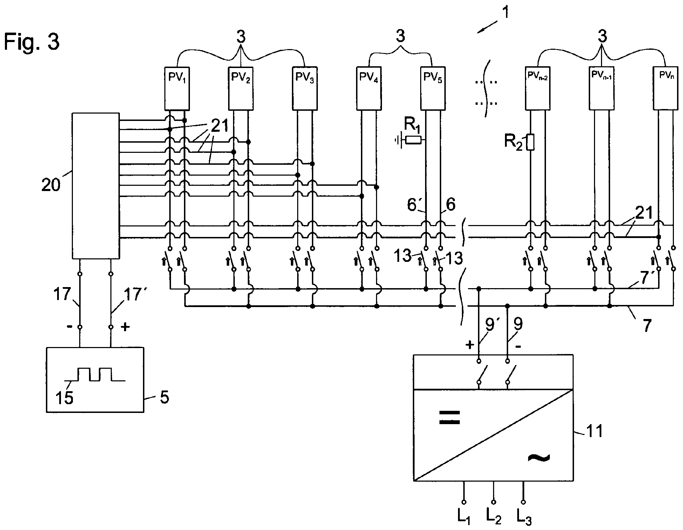

Bei der in der Figur 2 dargestellten, zweiten Ausführungsform der Erfindung gibt der Isolationswächter 5 den Testimpuls 15 auf zwei Testimpuls-Sammelleitungen 17,17' von der er erfindungsgemäß mittels zweiter oder weiterer, zweipoliger Schalter S auf Anschlussleitungen 21,21', später in Zusammenhang mit der Fig. 3 auch Stichleitungen 21,21' genannt, schaltbar ist, die jeweils in zugeordnete Zuleitungen 6,6' münden.

Soll die erste Teilanlage PV1 auf Isolationsschwächen getestet werden, so werden alle weiteren Schalter S2 bis Sn der Teilanlagen PV2 bis PVn geöffnet und lediglich der Schalter S1, der die Zuleitungen 6,6' der ersten Teilanlage PV1 mit den Testimpuls-Sammelschienen 17,17' verbindet, wird geschlossen. Auf diese Weise wird auch bei der Großanlage 1 die Möglichkeit eröffnet, mit einem konventionellen Isolationswächter 5 in gehabter Weise die Isolation zu überprüfen.

So werden nach und nach alle Teilanlagen PVn an den Isolationswächter 5 angeschlossen, indem nur der jeweilige Schalter S, der der zu überprüfenden Teilanlage PV zugeordnet ist, geschlossen ist, während alle anderen Schalter S geöffnet bleiben. Diese Aufteilung der Gesamtanlage 1 in Teilanlagen 3, die jeweils mittels der Schalter S1 bis Sn an den Isolationswächter 5 angeschlossen sind, ist als Aufgliederung im Sinne der Ansprüche zu verstehen.

In der Figur 3 ist noch eine dritte Variante gezeigt, in der die Schalter S durch einen Multiplexer 20 ersetzt sind, an dessen Ausgängen die Zuleitungen oder Stichleitungen 21 angeschlossen sind, die den Testimpuls 15 vom Multiplexer 20 zu den Zuleitungen 6,6' weiterleiten.

### Bezugszeichenliste

- 1: Photovoltaik-Großanlage
- 3,: PVn Teilanlagen
- 5: Isolationswächter
- 6,6': Zuleitungen zu PV-Teilanlagen
- 7,7': Sammelleitungen
- 9,9': Anschlusspole Wechselrichter
- 10,10': Strommessgerät
- 11: Wechselrichter
- 13: Trennschalter
- 14: Analyseeinheit
- 15: Testimpuls
- 17,17': Testimpuls-Sammelleitungen
- 20: Multiplexer
- 21: Stichleitung
- S: Schalter

## Patentansprüche

1. Verfahren zur Überprüfung der Isolation einer Photovoltaikanlage (1) gegenüber Erde mit Hilfe eines auf die Anschlussleitungen (6,6') der Photovoltaikanlage gegebenen Testimpulses (15), **dadurch gekennzeichnet, dass** die Photovoltaikanlage schaltungstechnisch in mehrere, elektrisch voneinander isolierte Teilanlagen (3) gegliedert wird, und der Testimpuls nacheinander auf die der jeweiligen Teilanlage zugeordnete Anschlussleitung (6,6') gegeben wird.

2. Verfahren zur Überprüfung der Isolation einer Photovoltaikanlage (1) gegenüber Erde mit Hilfe eines auf die Anschlussleitungen (6,6') der Photovoltaikanlage gegebenen Testimpulses (15), **dadurch gekennzeichnet, dass** der Stromverlauf des Testimpuls (15) durch die Anschlussleitungen (6,6') mittels Stromsensoren (10,10') erfasst und in einer Analyseeinheit (14) ausgewertet wird

3. Verfahren nach Anspruch 2, **dadurch gekennzeichnet, dass** der Verlauf des Testimpulses (15) mit einem entsprechenden Verlauf zu einem früheren Zeitpunkt verglichen wird.

4. Verfahren nach Anspruch 2 oder 3, **dadurch gekennzeichnet, dass** die Stromsensoren (10,10') an den von einer Sammelschiene (7,7') ausgehenden Zuleitungen (6,6') zu den Teilanlagen (3) der Photovoltaikanlage eingesetzt werden.

5. Verfahren nach einem der Ansprüche 2 bis 4, **dadurch gekennzeichnet, dass** Schaltmittel (13) die jeweiligen Anschlussleitungen (6,6') zu einzelnen Teilanlagen (3) an zwei Sammelschienen (7,7') zuschalten oder von ihnen trennen, wobei die Sammelschienen mit dem Eingang eines Wechselrichters (11) verbunden sind.

6. Verfahren nach Anspruch 1, **dadurch gekennzeichnet, dass** weitere Schaltmittel (S) die jeweiligen Anschlussleitungen (6,6') zu den einzelnen Teilanlagen (3) an eine Testimpuls-Sammelleitung (17,17'), auf die der Testimpuls (15) gegeben wird, zuschalten oder von ihr trennen.

7. Verfahren nach Anspruch 1 oder 6, **dadurch gekennzeichnet, dass** jede Teilanlage (3) mehrere Photovoltaikfelder umfasst und einzeln auf eine Sammelschiene (7,7') zuschaltbar ist, die an den Eingang eines Wechselrichters (11) geführt ist.

8. Verfahren nach Anspruch 1, 6 oder 7, **dadurch gekennzeichnet, dass** jede Teilanlage (3) über ein zweipoliges Schaltmittel (S) an den Ausgang eines den Testimpuls (15) generierenden Isolationswächters (5) angeschlossen ist

9. Verfahren nach Anspruch 8, **dadurch gekennzeichnet, dass** das zweipolige Schaltmittel ein Multiplexer (20) ist, der nacheinander das Testsignal (15) auf an den Ausgang des Multiplexers (20) angeschlossene Anschlussleitungen (21,21') gibt, die jeweils zu den Leitungen (6,6') für die jeweiligen Teilanlagen (3) führen.

10. Verfahren nach Anspruch 8, **dadurch gekennzeichnet, dass** das zweipolige Schaltmittel (S) eine Vielzahl von elektronischen Schaltern umfasst, die die beiden jeweiligen Anschlussleitungen (6,6') zu den Teilanlagen (3) an eine Testimpuls-Sammelleitung (17,17') schaltet oder von ihr trennt, auf welcher der Testimpuls (15) gegeben und von dort an die einzelnen Teilanlagen (3) verteilt wird.

## Claims

1. A method for checking the insulation of a photovoltaic system (1) with respect to ground by means of a test pulse (15) applied to the connection lines (6, 6') of the photovoltaic system, **characterized in that** the photovoltaic system is divided as to its circuitry into several subsystems (3) electrically insulated from each other, and the test pulse is successively applied to the connection lines (6, 6') assigned to the respective subsystem.

2. A method for checking the insulation of a photovoltaic system (1) with respect to ground by means of a test pulse (15) applied to the connection lines (6, 6') of the photovoltaic system, **characterized in that** the current path of the test pulse (15) through the connection lines (6, 6') is detected by means of current sensors (10, 10') and is evaluated in an analytical unit (14).

3. A method according to Claim 2, **characterized in that** the path of the test pulse (15) is compared with a corresponding path at an earlier point in time.

4. A method according to Claim 2 or 3, **characterized in that** the current sensors (10, 10') are used on the feed lines (6, 6') leading from a bus bar (7, 7') to the subsystems (3) of the photovoltaic system.

5. A method according to any one of Claims 2 to 4, **characterized in that** switching means (13) connect the respective connection lines (6, 6') to the individual subsystems (3) to the two bus bars (7, 7') or disconnect them from them, wherein the bus bars are connected with the input of an inverter (11).

6. A method according to Claim 1, **characterized in that** further switching means (S) connect the respective connection lines (6, 6') to the individual subsystems (3) to a test pulse-collecting line (17, 17') on which the test pulse (15) is applied, or disconnect it from them.

7. A method according to Claim 1 or 6, **characterized in that** each subsystem (3) comprises a plurality of photovoltaic fields and can be connected individually to a bus bar (7,7'), which is connected to the input of an inverter (11).

8. A method according to Claim 1, 6 or 7, **characterized in that** each subsystem (3) is connected via a two-pole switching means to the output of an insulation monitor (5) generating the test pulse (15).

9. A method according to Claim 8, **characterized in that** the two-pole switching means is a multiplexer (20), which successively applies the test signal (15) to connection lines (21, 21') connected to the output of the multiplexer (20), which in each case connect to the lines (6, 6') for the respective subsystems (3).

10. A method according to Claim 8 **characterized in that** the two-pole switching means (S) comprises a plurality of electronic switches, which connect the two respective connection lines (6, 6') to the subsystems (3) to a test pulse-collecting line (17, 17') or disconnects them from it, on which the test pulse (15) is applied and is distributed from there to the individual subsystems (3).

## Revendications

1. Procédé de vérification de l'isolement d'une installation photovoltaïque (1) par rapport à la terre à l'aide d'une impulsion-test (15) délivrée sur les lignes de connexion (6, 6') de l'installation photovoltaïque, **caractérisé en ce que** l'installation photovoltaïque est structurée, au plan du circuit, en plusieurs installations partielles (3) électriquement isolées les unes des autres, et l'impulsion-test est délivrée successivement sur la ligne de connexion (6, 6') affectée à l'installation partielle.

2. Procédé de vérification de l'isolement d'une installation photovoltaïque (1) par rapport à la terre à l'aide d'une impulsion-test (15) délivrée sur les lignes de connexion (6, 6') de l'installation photovoltaïque, **caractérisé en ce que** l'allure du courant de l'impulsion-test (15) à travers les lignes de connexion (6, 6') est détectée au moyens de capteurs de courant (10, 10') et analysée dans une unité d'analyse (14) .

3. Procédé selon la revendication 2, **caractérisé en ce que** l'allure de l'impulsion-test (15) est comparée avec une allure correspondante à un moment antérieur.

4. Procédé selon la revendication 2 ou 3, **caractérisé en ce que** les capteurs de courant (10, 10') sont mis en oeuvre sur les lignes d'alimentation (6, 6') en provenance d'une barre omnibus (7, 7') et conduisant aux installations partielles (3) de l'installation photovoltaïque.

5. Procédé selon l'une des revendications 2 à 4, **caractérisé en ce que** des moyens de commutation (13) branchent les lignes de connexion (6, 6') respectives des différentes installations partielles (3) sur deux barres omnibus (7, 7') ou les en séparent, les barres omnibus étant connectées à l'entrée d'un onduleur (11).

6. Procédé selon la revendication 1, **caractérisé en ce que** d'autres moyens de commutation (S) branchent les lignes de connexion (6, 6') respectives des différentes installations partielles (3) sur une ligne collectrice d'impulsion-test (17, 17') sur laquelle est délivrée l'impulsion-test (15) ou les en séparent.

7. Procédé selon la revendication 1 ou 6, **caractérisé en ce que** chaque installation partielle (3) comprend plusieurs groupes photovoltaïques et peut être branchée individuellement sur une barre omnibus (7, 7') qui est conduite à l'entrée d'un onduleur (11).

8. Procédé selon la revendication 1, 6 ou 7, **caractérisé en ce que** chaque installation partielle (3) est, par le biais d'un moyen de commutation (S) à deux pôles, connectée à la sortie d'un contrôleur d'isolement (5) générant l'impulsion-test (15).

9. Procédé selon la revendication 8, **caractérisé en ce que** le moyen de commutation à deux pôles est un multiplexeur (20) qui délivre successivement l'impulsion-test (15) à des lignes de connexion (21, 21') connectées à la sortie du multiplexeur (20) qui conduisent respectivement aux lignes (6, 6') pour les installations partielles (3) respectives.

10. Procédé selon la revendication 8, **caractérisé en ce que** le moyen de commutation (S) à deux pôles comprend une multiplicité de commutateurs électroniques qui commutent les deux lignes de connexion (6, 6') respectives des installations partielles (3) à une ligne collectrice d'impulsion-test (17, 17'), ou qui les en séparent, sur laquelle l'impulsion-test (15) est délivrée et est distribuée à partir de là aux différentes installations partielles (3).
